# EUROPEAN PATENT APPLICATION

(11) **EP 0 600 449 A2**
(43) Date of publication of application: **08.06.1994**
(21) Application number: 93119301.5
(22) Date of filing: 30.11.1993
(51) Int. Cl.: H01L 21/76, H01L 27/06

(54) **Fabrication method of compound semiconductor integrated circuit device**

(30) Priority: 01.12.1992 JP 321744/92
(71) Applicant: NEC CORPORATION, Tokyo (JP)
(72) Inventor: Asai, Shuji, c/o NEC Corporation, Minato-ku, Tokyo (JP)
(74) Representative: Glawe, Delfs, Moll & Partner

(57) **Abstract**

A fabrication method of a compound semiconductor integrated circuit device, in which the backgating effect and the sidegating effect are restricted thereby to improve its device-isolation characteristics and productivity without using a low-temperature buffer layer. After a crystal-defective layer is formed on a main surface of a compound semiconductor substrate by an ion-implantation technique, an active layer is formed thereon and then a compound semiconductor buffer layer is formed on the buffer layer. Next, a recess for isolation purpose is selectively formed to make device regions through the active layer with extending to the buffer layer by an etching technique. Subsequently, a gate electrode and source and drain electrodes are formed on the active layer and a backgate electrode is formed on the reverse side of the substrate.

## Description

### BACKGROUND OF THE INVENTION

### 1. Field of the Invention

The present invention relates to a fabrication method of a compound semiconductor integrated circuit device and more particularly, to a fabrication method of a compound semiconductor integrated circuit device containing Field Effect Transistors (FETs), in which the device-isolation characteristics have been improved.

### 2. Description of the Prior Art

Gallium arsenide (GaAs) and other compound semiconductors have been put into practical applications such as FETs using their layers grown by a Molecular Beam Epitaxy (MBE) technique and integrated circuit devices using the FETs for ultra-high frequency band applications due to their greater electron mobility than that of silicone (Si). Integrated circuit devices using those compound semiconductors have been developed for analog signal amplification, digital signal processing and the like.

In putting those compound semiconductor integrated circuit devices into practical use, an important problem about the sidegating and backgating effects has been raised, which make the device-isolation characteristics of the integrated circuit device deteriorate. The "sidegating effect" means a phenomenon in which a channel electric field in an active layer of a compound semiconductor FET fluctuates or modulated through its semiconductor substrate due to the electric potential fluctuation between the FET and its adjacent device(s) or element(s) thereby to influence the characteristics of the FET such as the drain current.

The "backgating effect" means the phenomenon in which a channel electric field in an active layer of a compound semiconductor FET fluctuates or modulated through its semiconductor substrate due to the electric potential fluctuation of its back-gate grounded thereby to influence the characteristics of the FET such as the drain current.

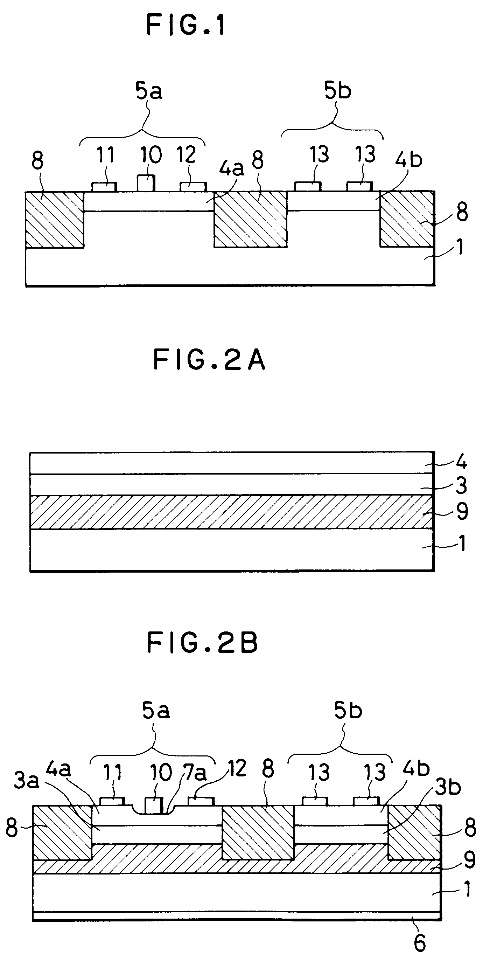

Fig 1 shows an example of a compound semiconductor FET in which the sidegating effect is improved. The FET is disclosed in IEEE Electron Device Letters, Vol. EDL-4, No. 4, PP. 102-103, April 1983, entitled "Self-Aligned Sub-micron Gate GaAs Integrated Circuits".

In Fig. 1, on a main surface of a semi-insulating GaAs substrate 1 a crystal-defective region 8 for device-isolation is selectively formed surrounding a first device region 5a and a second device region 5b by an ion-implantation technique using ions such as proton (H⁺), boron ions (R⁺) and oxygen ions (O⁺). An FET is formed in the first device region 5a and a resistor is formed in the second device region 5b, and both of the regions 5a and 5b are electrically isolated from each other by the region 8. The lower end of the region 8 is disposed in the substrate 1.

Within the first device region 5a a GaAs active layer 4a is formed on the main surface of the GaAs substrate 1 and source and drain electrodes 11 and 12 of the FET are formed apart on the active layer 4a. A gate electrode 10 is also formed on the active layer 4a in the middle of the source and drain electrodes 11 and 12.

Within the second device region 5b a GaAs active layer 4b is formed on the main surface of the GaAs substrate 1 and a pair of terminal electrodes 13 for the resistor are formed apart on the active layer 4b.

In the prior-art semiconductor integrated circuit device shown in Fig. 1, only the crystal-defective region 8 inhibits the sidegating effect due to a second FET (not shown) adjacent the FET. Therefore, when the gate electrode area of the second FET is much larger than the surface area of the FET itself and/or when the electric potential of a back gate (not shown) formed on the bask of the substrate 1 changes, the characteristics of the FET in the first device region 5a may fluctuate because the electric potential fluctuation affects the FET in the device region 5a through a path under the crystal-defective region 8 in the substrate 1 thereby to weaken the function of the region 8.

A compound semiconductor integrated circuit device which solves the problem in the device shown in Fig. 1 is disclosed in IEEE, Transactions on Electron Devices, Vol. 37, No. 1, January 1990, PP. 46-49 entitled "Anomalies in MODFET's with a Low Temperature Buffer", which has a GaAs buffer layer grown at a low temperature of 200 to 300 °C and an undoped GaAs buffer layer between a semi-insulating GaAs substrate and a GaAs active layer. An sample of a prior art compound semiconductor integrated circuit device employed the low-temperature buffer layer is shown in Figs. 2A and 2B.

As shown in Fig. 2B, there is formed on a main surface of a semi-insulating GaAs substrate 1 with a thickness of 500 µm a low-temperature GaAs buffer layer 9 with a thickness of 0.5 µm. A crystal-defective region 8 for device-isolation is formed on the GaAs buffer layer 9 so as to surround a first device region 5a and a second device region 5b. An FET is formed in the first device region 5a and a resistor is formed in the second device region 5b, and both of the regions 5a and 5b are electrically isolated from each other by the region 8.

In the first device region 5a, an undoped GaAs buffer layer 3a is formed on the low-temperature GaAs buffer layer 9 and a GaAs active layer 4a having a shallow recess 7a on its central surface is formed on the buffer layer 3a. source and drain electrodes 11 and 12 of the FET are formed apart on the active layer 4a. A gate electrode 10 is also formed on the active layer 4a in the middle of the source and drain electrodes 11 and 12.

In the second device region 5b an undoped GaAs buffer layer 3b is formed on the low-temperature GaAs buffer layer 9 and a GaAs active layer 4b is formed on the buffer layer 3b. A pair of terminal electrodes 13 for the resistor are formed apart on the active layer 4b.

On the reverse side of the semi-insulated GaAs substrate 1 a backgate 6 is formed.

The fabrication method thereof will be explained below.

First, as shown in Fig. 2A, by a Molecular Beam Epitaxy (MBE) technique, the GaAs buffer layer 9 with a high electric resistance is grown epitaxially on the main surface of the semi-insulated GaAs substrate 1 at a low temperature and then, the undoped GaAs buffer layer 3 is grown epitaxially on the buffer layer 9.

GaAs-system semiconductor layers are generally grown epitaxially by the MBE technique at a temperature of of about 600 °C, however, in the device shown in Figs. 2A and 2B the GaAs buffer layer 9 is grown at a low temperature of 200 - 300 °C. The growth at such the low temperature enables a polycrystalline or crystal-grained high-resistance layer to be formed with an excessive supply of arsenic (As).

In the prior art device, the surface of the GaAs substrate 1 is cleaned by receiving As beams at a temperature raised to 650 °C and then, cooled to 300 °C for epitaxial growth of the low- temperature GaAs buffer layer 9 and the undoped GaAs buffer layer 3. Thereafter, the temperature of the substrate 1 is again raised to 600 °C to epitaxially grow on the buffer layer 3 the GaAs active layer 4 in which a channel is formed, the state of which is shown in Fig. 2A.

Next, as shown in Fig. 2B, the crystal-defective region 8 is formed by an ion-implantation technique using ions such as protons (H⁺), boron ions (B⁺) and oxygen ions (O⁺) thereby to make the first and second device regions 5a and 5b. In the first device region 5a the surface of the active layer 4a is selectively etched at a position where the gate electrode 10 is to be formed thereby to form the shallow recess 7a.

Then, on the active layer 4a in the first device region 5a the source and drain electrodes 11 and 12 are formed, and on the shallow recess 7a the gate electrode 10 is formed to complete the first device region 5a. On the active layer 4b in the second device region 5b the pair of terminal electrodes 13 of the resistance is formed to complete the second device region 5b. Finally, after grinding the reverse side of the GaAs substrate 1 to a given thickness, the backgate electrode 6 is formed thereon. Thus, the integrated circuit device as shown in Fig. 2B is obtained.

In the integrated circuit device shown in Figs. 2A and 2B, the low-temperature GaAs buffer layer 9 is placed under the first and second device regions 5a and 5b and the crystal-defective region 8 formed by the ion-implantation technique is placed so as to surround the respective regions 5a and 5b. Therefore, the resistances against both of the sidegating effect and the backgating effect in the low-frequency operation can be improved.

With the device Shown in Figs. 2A and 2B, investigation about the transient characteristics of the FET was carried out. As a result, the drain current of the FET was reduced for a transient period of about 10 msec in response to change of electric potential pulses applied to the backgate 6 and then recovered to its normal value. This means that the backgating effect had momentarily taken place. In addition, it was found that the lower the ambient temperature, the longer the period of time when the effect or the transient change of the drain current appears. Further in addition, similar to the device shown in Fig. 1, it was found that when an FET having a large-area gate electrode was provided adjacent to the FET in the first device area 5a, the characteristics of the FET in the area 5a fluctuated due to the backgating effect.

Such the fluctuation in FET characteristics of a 10-msec order raises the following problems:
A first problem is that a high-speed logic circuit with a clock period of 1 µsec or less may malfunction.

A second problem is that a three-dimensional logic circuit with vertically stacked FETs and/or an active load composed of an FET whose gate and source are connected to each other may malfunction. The reason is that there is a possibility of fluctuation in source potential of the FET even if the backgate electrode potential does not change and as a result, the backgate electrode potential changes relative to the source potential. This problem is easy to occur when power consumption of the logic circuit is reduced to shrink its logic margins.

To restrict the transient fluctuation of the drain current due to the backgating effect, if the density of crystal defects in the low-temperature GaAs buffer layer 9 is increased by growing the layer 9 at a temperature lowered to 250 °C, there arises another problem that the carrier mobility in the active layer 4 decreases.

When the growth temperature of the low-temperature GaAs buffer layer 9 is lowered to 250 °C, observation of the growing active layer 4 by a reflection high-energy electron diffraction (RHEED) showed that its crystalline characteristics was poorer, due to the lower temperature and even if the active layer 4 further continued to be grown at a temperature raised to 600 °C, the crystalline characteristics of the layer 9 recovered slightly. Additionally, As is precipitated on the grain boundaries of the low-temperature GaAs buffer layer 9 due to a wet-etching and/or a X-ray spectroscopy process and as a result, if the density of the crystal-defects in the low-temperature GaAs buffer layer 9 is made large, there is a possibility that the active layer 4 formed on the layer 9 is made polycrystalline. This means that the density of defects in the buffer layer 9 has its upper limit. Therefore, it is difficult, to restrict the transient fluctuation of the drain current by increasing the density of the crystal-defects in the buffer layer 9.

In the processes of growing the buffer layers 9 and 3 and the active layer 4, the temperature of a wafer holder of the MBE apparatus, in which several wafers or semiconductor substrates are set, is required to be lowered from 650 °C to 300 °C and then raised to 600 °C. This means that each of the processes takes another 20 minutes or more for the temperature being stabilized. In other words, when the MBE processes for all the wafers in the holder requires are finished, it takes an extra time, for example about one hour, for the temperature stabilization, resulting in a lower fabrication yield.

### SUMMARY OF THE INVENTION

Accordingly, an object of the present invention is to provide a fabrication method or a compound semiconductor integrated circuit device in which the backgating and sidegating effects can be restricted so that the operation stability of the compound semiconductor integrated circuit device can be improved.

Another object of the present invention is to provide a fabrication method of a compound semiconductor integrated circuit device in which the isolation characteristics of the compound semiconductor integrated circuit device can be improved without using the low-temperature buffer layer in the prior art and the productivity is also high.

A fabrication method of a compound semiconductor integrated circuit device according to a first aspect of the present invention comprises a step of forming a crystal-defective layer on a main surface of a compound semiconductor substrate by an ion-implantation technique, a step of epitaxially growing a compound semiconductor buffer layer on the crystal-defective layer at a temperature higher than that of a semiconductor low-temperature buffer layer, a step of epitaxially growing a compound semiconductor active layer on the buffer layer, and a step of selectively forming a recess for isolation purpose to make device regions through the active layer with extending to the buffer layer by an etching technique.

A fabrication method of a compound semiconductor integrated circuit device according to a second aspect of the present invention comprises a step of forming a crystal-defective layer on a main surface of a compound semiconductor substrate by an ion-implantation technique, a step of epitaxially growing a compound semiconductor buffer layer on the crystal-defective layer at a temperature higher than that of a semiconductor low-temperature buffer layer, a step of epitaxially growing a compound semiconductor active layer on the buffer layer, and a step of selectively forming a crystal-defective region for isolation purpose to make device regions through the active layer and the buffer layer with extending to the crystal-defective layer by an ion-implantation technique.

In the fabrication methods of the first and second aspects, it is sufficient for the present invention that the growth temperature (or substrate temperature) of the buffer layer is higher than the temperature of about 200 to 300°C. The growth temperature of the buffer layer is typically about 600 °C, however, it may be 500 °C or high.

It has been confirmed by an electron diffraction that ion-implantation onto the surface of the semiconductor substrate causes the atoms constituting the substate crystal to slightly deviate from their lattice positions due to collision with the ions implanted, resulting in microscopic crystal defects of an atomic size order. It has also been confirmed that when the buffer layer is epitaxially grown at 600 µC subsequently over the entire surface of the substrate, the crystalline characteristics of the buffer layer thus grown start to recover rapidly after the thickness of the buffer layer becomes about 300 nm.

In addition, the larger the amount of the ions implanted, or dose, in the crystal-defective layer and the thinner the buffer layer, the lower the carrier mobility in the active layer grown on the buffer layer. However, reduction of the carrier mobility under practical ion-implantation conditions is restricted to several tens % of that in the case of no crystal-defective layer being provided.

Accordingly, with the fabrication method of the first aspect, by the crystal-defective layer formed by the ion-implantation technique onto the substrate and the recess for isolation purpose, the sidegating effect and backgating effect are restricted effectively with limited reduction of the carrier mobility. With the fabrication method of the second aspect, by the crystal-defective layer formed, by the ion-implantation technique onto the substrate and the crystal-defective region for isolation purpose formed by the ion-implantation technique, the sidegating effect and backgating effect are restricted effectively with limited reduction of the carrier mobility. As a result, the isolation characteristics of the compound semiconductor integrated circuit device can be improved and the operation characteristics thereof can be stabilized.

An improved productivity can be obtained since the complex process of growing the low-temperature buffer layer, which requires a long time, does not needed.

There is an additional advantage that the crystalline characteristics of the active layer formed on the buffer layer does not deteriorate compared with the prior art where the low-temperature buffer layer is employed.

The buffer layer and the active layer may be grown by using any epitaxial growth technique such as a molecular beam epitaxy (MBE) technique and a metal-organic vapor phase epitaxy (MOVPE) technique.

### BRIEF DESCRIPTION OF THE DRAWINGS

Fig. 1 is a partial cross-sectional view showing an example of the prior-art compound semiconductor integrated circuit device.

Figs. 2A and 2B show fabrication sequence of another example of the prior-art compound semiconductor integrated circuit device, respectively.

Figs. 3A to 3C show a fabrication method of a compound semiconductor integrated circuit device according to a first embodiment of the present invention, respectively.

Figs. 4A and 4B show a fabrication method of a compound semiconductor integrated circuit device according to a second embodiment of the present invention, respectively.

Figs. 5A to 5D show a fabrication methods of a compound semiconductor integrated circuit device according to a third embodiment of the present invention, respectively.

Fig. 6 is a partial cross-sectional view showing the active layer of the compound semiconductor integrated circuit device shown in Figs 3A to 3C.

Fig. 7 is a partial cross-sectional view showing another example of the buffer layer of the compounds semiconductor ingetrated circuit device shown in Figs 3A to 3C.

### DETAILED DESCRIPTION OF THE PREFERRED EMBODIMENTS

Preferred embodiments of the present invention will be described below with reference to the drawings attached.

### [First embodiment]

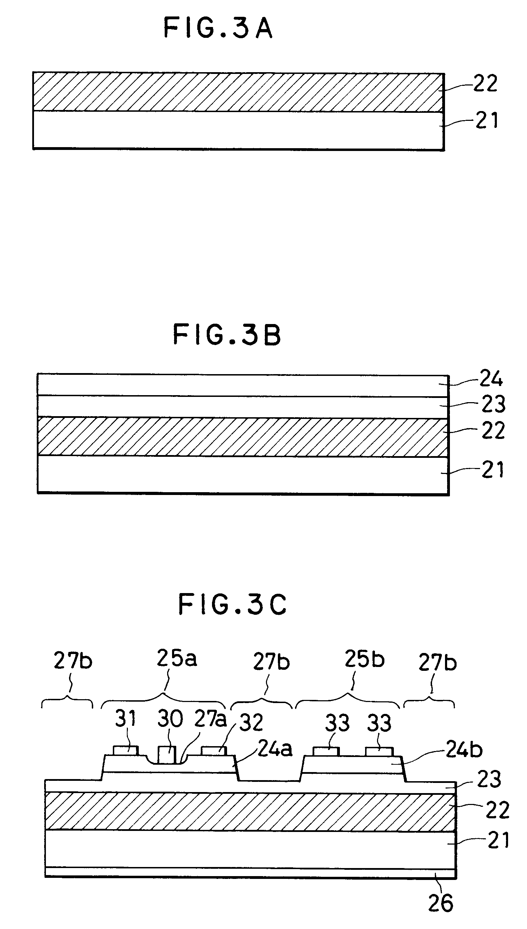

Figs. 3A to 3C show a fabrication method of a compound semiconductor integrated circuit device containing an FET according to a first embodiment.

First, as shown, in Fig. 3A, on the surface of a semi-insulating GaAs substrate 21 having a thickness of 500 µm a crystal-defective layer 22 is formed by an ion-implantation technique using boron ions (B⁺) at an acceleration energy of 200 keV with a dose of 1 × 10¹⁵ cm⁻².

If the maximum or highest temperature in the subsequent heat-treatment process becomes higher, a larger amount of the crystal defects of the layer 22 due to the ion-implantation process becomes to restore, so that the dose of the crystal-defective layer formation process should be increased, However, it is necessary to optimize the dose in accordance with the maximum temperature due to the reason that a too large dose results in an increase in leak current.

With the ions to be implanted, protons (H⁺) are not appropriate because the crystal-defects of the layer 22 are remedied at a temperature near 500 °C. On the other hand, large-mass ions are not also suitable for a 200-keV ion-implantation system generally used since the crystal-defective layer 22 must be deep to a certain extent. Accordingly, it is desirable to employ boron ions (B⁺), oxygen ions (0⁺) or nitrogen ions (N⁺) in practical use. In the case of the maximum temperature of the heat-treatment process being at 600 °C, boron ions (B⁺) are the best to use because the crystal-defects of the layer 22 is difficult to be remedied and the activation efficiency is less at this temperature.

Next, using an MBE growth system where the maximum pressure is 10⁻¹⁰ Torr or less, the semi-insulating GaAs substrate 21 is heated to 650 °C while the surface of the substrate 21 being irradiated with As molecular beams so that contaminations existing on the surface is evaporated. Thereafter, it is confirmed whether or not the surface of the substrate 21 has been cleaned using an image obtained through a Reflection High-Energy Electron Diffraction (RHEED) technique.

Then, as shown in Fig. 3B, an undoped GaAs buffer layer 23 with a thickness of 500 nm is grown on the crystal-defective layer 22 after the temperature of the substrate 21 has been lowered to 600 °C.

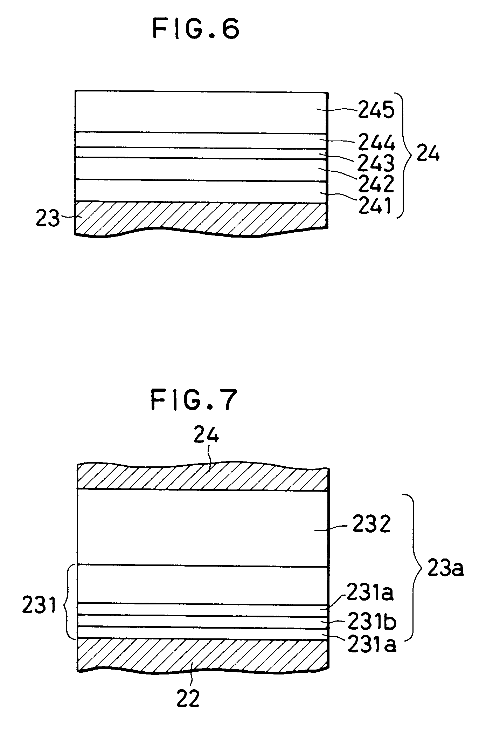

To form an active layer 24 on the GaAs buffer layer 23, as shown in Fig. 6, an undoped Al_{0.3}Ga_{0.7}As layer 241 with a thickness of 50 nm, an undoped GaAs layer 242 with a thickness of 50 nm, an N-type GaAs layer 243 doped with silicone (Si) at a concentration of 2 × 10¹⁸ cm⁻³ and having a thickness of 15 nm, an undoped Al_{0.3}Ga_{0.7}As layer 244 with a thickness of 20 nm, and an N-type GaAs layer 245 doped with Si at a concentration of 2 × 10¹⁸ cm⁻³ and having a thickness of 100 nm are grown successively in this order. The growth speed at the process is about 10 nm/min.

Next, as shown in Fig. 3C, at a position where a first device region 25a is to be provided, a shallow recess 27a is formed by selectively etching the entirety of the N-type GaAs layer 245 and a part of the undoped Al_{0.3}Ga_{0.7}As layer 244 of the active layer 24. Then, a deep recess 27b for isolation purpose is formed by selectively etching the entirety of the active layer 24 and a part of the buffer layer 23 thereby to make the first device region 25a and a second device region 25b.

On the surface of an active layer 24a at the shallow recess 27a in the first device region 25a a gate electrode 30 is formed, and a source electrode 31 and a drain electrode 32 are formed on the surface of the active layer 24a at the each side of the recess 27a. On the surface of an active layer 24b in the second device region 25b a pair of terminal electrodes 33 of a resistor are formed. Thus, the first and second device regions are completed.

Finally, after the reverse- or back-side of the GaAs substrate 21 is ground to be finished to a thickness of 300 µm, a backgate electrode 26 composed of a 10-nm-thick titanium (Ti) film and a 300-nm-thick gold (Au) film is formed thereon. Thus, the GaAs integrated circuit device of the first embodiment is obtained.

In the device thus obtained, the crystal-defective layer 22 is formed on the main surface of the GaAs substrate 21 through the ion-implantation process and on the crystal-defective layer 22 the undoped GaAs buffer layer 23 is formed. The first and second device regions 25a and 25b are formed on the undoped GaAs buffer layer 23 are provided and the both regions 25a and 25b are electrically isolated from each other by the deep recess 27b.

Accordingly, the backgating effect is chiefly restricted by the crystal-defective layer 22 and the sidegating effect is restricted by the recess 27b with limited reduction of the carrier mobility. As a result, the isolation characteristics of the GaAs integrated circuit device of the embodiment can be improved and the operation characteristics thereof can be stabilized.

Additionally, since the complex process of growing the low-temperature buffer layer, which requires a long time for temperature stabilization, does not needed, a period of time required for fabricating the integrated circuit device can be reduced, resulting an improved productivity.

In the first embodiment, the transient response characteristics to the electric potential applied to the backgate electrode 26 was investigated. As a result, when 1-msec potential pulses are applied to the backgate electrode 26, the drain current was reduced by 10%, resulting in the backgate resistance of about -30 V. Diminishing the pulse length as far as 1 µsec reduced the backgate resistance to about -24 V. Both valves of the resistances are sufficient for the FET characteristics not to be affected due to the backgating effect.

Moreover, when a second FET was placed 10 µm apart from the FET in the first device region 25a and the gate electrode of the second FET serves as a sidegate electrode, the sidegate resistance was about -7 V. This value of the resistance is also sufficient for the FET characteristics not to be affected due to the sidegating effect even if a large-area sidegate electrode is provided adjacent to the FET in the first device region 25a.

In the case of the low-temperature GaAs buffer layer shown in Figs. 2A and 2B, the backgate resistance value against 1-msec potential pulses is -3 V and the sidegate resistance value against the same is -1 V. Both of the values are much lower than these in the first embodiment.

For the MBE growth system of the first embodiment, 10 semi-insulating GaAs substrates are set in the wafer holder. It took about 90 minutes from the time when this wafer bolder was automatically carried from the vacuum chamber to the growth chamber to that when the epitaxial growth processes completed. The period of time required for the ion-implantation process in the first embodiment was several minutes per substrate, indicating that the period of time required for the fabrication method of the embodiment can be shortened substantially.

If the thickness of the undoped GaAs buffer layer 23 is increased to reduce dislocation defects in the layer 23,there arises a problem that the sidegate resistance is deteriorated. As a countermeasure to the problem, a buffer layer 23a as shown in Fig. 7 may be provided. The buffer layer 23a is composed of a super-lattice layer 231 formed on the crystal-defective layer 22 and an undoped GaAs buffer layer 232 with a thickness of 300 nm formed on the super-lattice layer 231. The super-lattice layer 231 has a multi-layer structure which is composed of undoped GaAs layers 231a each having a thickness of 5 nm and undoped Al_{0.3}Ga_{0.7}As layers 231b each having a thickness of 5 nm, each of the undoped GaAs layers 231a and each of the undoped Al_{0.3}Ga_{0.7}As layers 231b are alternately stacked in about 5 periods. In this case, the sidegate resistance can be improved to -12 V.

Meanwhile, in the case that the N-type GaAs layer 245 provided at the top of the active layer 24 is omitted,
the electron mobility in the active layer 24 serving as a channel was 7,000 cm²/Vs when the active layer 24 was grown directly on the main surface of the GaAs substrate 21 with no crystal-defective layer 22. The mobility was reduced about 10% to be 6,000 cm²/Vs when the active layer 24 was grown through the crystal-defective layer 22 on the main surface of the substrate 21, as in the first embodiment. Therefore, compared with the prior art in which the low-temperature GaAs buffer layer is employed as shown in Figs. 2A and 2B, the isolation characteristics of the integrated circuit device can be improved without substantially deteriorating the crystalline characteristics of the active layer 24.

Furthermore, the complex and long process of growing the low-temperature GaAs buffer layer can be eliminated.

In the first embodiment, the MBE technique is employed for epitaxial growth, however, a Vapor Phase Epitaxy (VPE) or a Liquid Phase Epitaxy (LEP) technique using a chloride, a hydride or an organic-metal may be employed, in which the same effects and advantages as the first embodiment are obtainable.

### [Second embodiment]

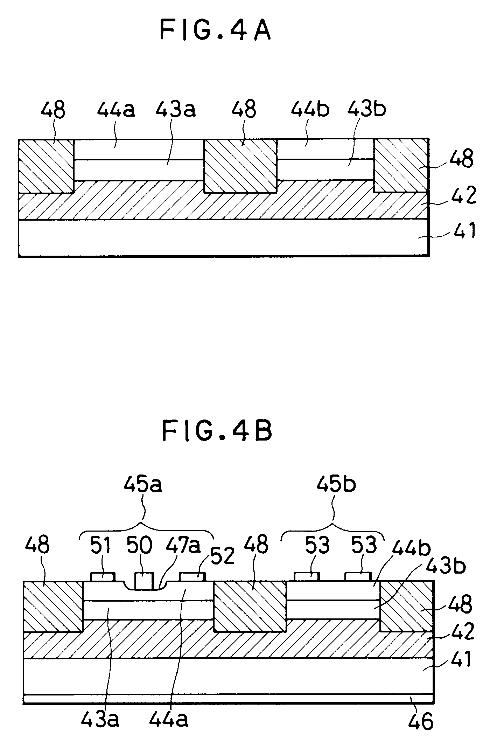

Next, a second embodiment will be explained below with reference to Figs. 4A and 4B.

First, on the surface of a semi-insulating GaAs substrate 41 having a thickness of 500 µm a crystal-defective layer 42 is formed by an ion-implantation technique using baron ions (B⁺) at an acceleration energy of 200 keV with a dose of 1 × 10¹⁵ cm⁻², as shown in Fig. 4A.

Next, using an MBE growth system where the maximums pressure is 10⁻¹⁰ Torr or less, the semi-insulating GaAs substrate 41 is heated to 650 °C while the surface of the substrate 41 being irradiated with As molecular beams so that contaminations existing on the surface is evaporated. Thereafter, it is confirmed whether or not the surface of the substrate 41 has been cleaned using an image obtained through a Reflection High-Energy Electron Diffraction (RHEED) technique.

Then, as shown in Fig. 4B, an undoped GaAs buffer layer with a thickness of 500 nm is grown on the surface of the crystal-defective layer 42 after the temperature of the substrate 41 has been lowered to 600 °C. An active layer 44 having the same structure as shown in Fig. 6 is formed on the GaAs buffer layer. The above processes are the same as in the first embodiment.

Next, a patterned photoresist film (not shown) with a thickness of 2 µm is formed on the active layer and then, a crystal-defective region 48 for isolation purpose is formed with the photoresist film as a mask by an ion-implantation technique using boron ions (B⁺) at an acceleration energy of 120 keV with a dose of 1 × 10¹³ cm⁻², as shown in Fig. 4A. The region 48 is extending through the entirety of the active layer and the buffer layer and to the inside of the crystal-defective layer 42. Thus, active layers 43a and 43b and buffer layers 44a and 44b are formed in first and second device regions 45a by the region 48, respectively.

As shown in Fig. 4B, at a position where a gate electrode in the first device region 45a to be provided, a shallow recess 47a is formed on the active layer 44a by selective etching.

Then, on the surface of the active layer 44a at the shallow recess 27a, a gate electrode 50 is formed and a source electrode 51 and a drain electrode 52 are formed on the active layer 44a at the each side of the recess 47a. On the active layer 44b in the second device region 45b a pair of terminal electrodes 53 of a resistor are formed. Thus, the first and second device regions 45a and 45b are completed.

Finally, after the reverse- or back-side of the GaAs substrate 41 is ground to be finished to a thickness of 300 µm, a backgate electrode 46, composed of a 10-nm-thick titanium (Ti) film and a 300-nm-thick gold (Au) film is formed thereon. Thus, the GaAs integrated circuit device of the second embodiment is obtained.

In the GaAs integrated circuit device of the second embodiment thus obtained, the crystal-defective layer 42 is formed on the main surface of the GaAs substrate 41 through the ion-implantation process and on the crystal-defective layer 42 the crystal-defective region 48 is formed. The first and second device regions 45a and 45b are electrically isolated from each other by the crystal-defective region 48 and crystal-defective layer 42.

Accordingly, similar to the first embodiment, the backgating effect is chiefly restricted by the crystal-defective layer 42 and the sidegating effect is restricted by the crystal-defective region 48 with limited reduction of the carrier mobility. As a result, the isolation characteristics of the GaAs integrated circuit device of the embodiment can be improved and the operation characteristics thereof can be stabilized.

In the second embodiment, the sidegate resistance against 1-msec potential pulses could be improved to -15 V when the isolation width is 1 µm.

### [Third embodiment]

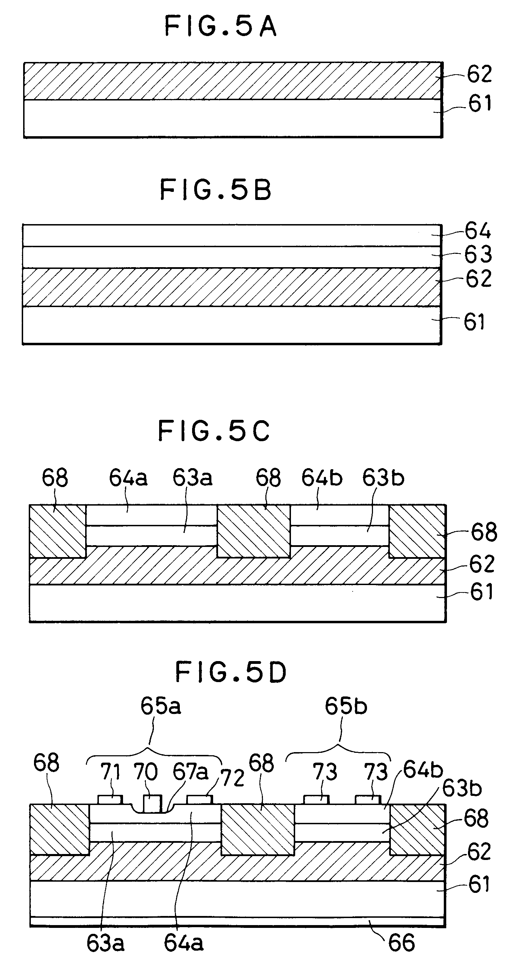

A fabrication methods of a third embodiment using a Metal Organic Vapor Phase Epitaxy (MOVPE) technique will be explained below with reference to Figs. 5A to 5D.

First, as shown in Fig. 5A, on the surface of a semi-insulating GaAs substrate 61 a crystal-defective layer 62 is formed by ion-implantation technique using boron ions (B⁺) at an acceleration energy of 200 keV with a dose of 5 × 10¹⁵ cm⁻². In the process, the dose is increased to 5 × 10¹⁵ cm⁻² compared with those in the first and second embodiments because the surface of the GaAs substrate 61 is required to be cleaned at a temperature of 650 °C
Using an MOVPE system in which the inside pressure of its growth chamber is 50 Torr, while supplying into the growth chamber hydrogen (H₂) gas at a flow rate of 5,000 cc/min and an arsine (AsH₃) gas at a flow rate of 40 cc/min, the temperature of the substrate 61 is raised to 650 °C and then kept at the same temperature for 20 minutes to clean the surface of the substrate 61.

Subsequently, the temperature of the substrate 61 is lowered to 550 °C and the inside pressure of the growth chamber is set at 50 Torr an then, an undoped GaAs buffer layer 63 with a thickness of 0.5 µm is epitaxially grown on the crystal-defective layer 62 while supplying an H₂ gas at a flow rate of 5,000 cc/min and an AsH₃ gas at a flow rate of 40 cc/min with supplying a trimethyl gallium ((CH₃)₃Ga) gas at a flow rate of 0.02 times as much as that of the AsH₃ gas, as shown in Fig. 5B.

Under the same conditions, a silane (SiH₄) gas is supplied into the growth chamber at a flow rate of 0.001 times as much as that of the AsH₃ gas to epitaxially grow on the buffer layer 63 an N-type GaAs active layer 64 having a thickness of 200 nm and a carrier concentration of 2 × 10¹⁷ cm⁻³.

Next, a crystal-defective region 62 is selectively formed by an ion-implantation technique using boron ions (B⁺), as shown in Fig. 5C. In the process, the boron ions are implanted into the entirety of the buffer layer 63 and the active layer 64 and a part of the crystal-defective layer 62. Thus, as shown in Fig. 5D, a first and second device regions 65a and 65b are made. In the first device region 65a a buffer layer 63a, and an active layer 64a are formed and in the second device region 65b a buffer layer 63b and an active layer 64a are formed.

Similar to the first and second embodiments, as shown in Fig. 5D, a gate electrode 70 is formed on the active layer 64a at its shallow recess 67a and a source and drain electrodes 71 and 72 are formed on the active layer 64a at each side of the recess 67a. A pair of terminal electrodes 73 of a resistor are formed on the active layer 64b.

Finally, the reverse side of the GaAs substrate 61 is ground to form a backgate electrode 66 thereon. Thus, the semiconductor integrated circuit device of the third embodiment is finished.

With the third embodiment, the MOVPE technique is employed instead of the MBE technique, so that the same effects and advantages as those in the first and second embodiments can be obtained.

The backgate resistance against 1 msec potential pulses can be improved to -20 V and the sidegate resistance to -9 V when the isolation width is 1 µm.

## Claims

1. A fabrication method of a compound semiconductor integrated circuit device, comprising the steps of:
forming a crystal-defective layer on a main surface of a compound semiconductor substrate by an ion-implantation technique;
epitaxially growing a compound semiconductor buffer layer on said crystal-defective layer at a temperature higher than that of a semiconductor low-temperature buffer layer;
epitaxially growing a compound semiconductor active layer on said buffer layer; and
selectively forming a recess for isolation purpose to make device regions through said active layer with extending to said buffer layer by an etching technique.

2. A fabrication method of a compound semiconductor integrated circuit device as claimed in claim 1, wherein boron ions are used in said step of forming said crystal-defective layer.

3. A fabrication method of a compound semiconductor integrated circuit device, comprising the steps of:
forming a crystal-defective layer on a main surface of a compound semiconductor substrate by an ion-implantation technique;
epitaxially growing a compound semiconductor buffer layer on said crystal-defective layer at a temperature higher than that of a semiconductor low-temperature buffer layer;
epitaxially growing a compound semiconductor active layer on said buffer layer; and
selectively forming a crystal-defective region for isolation purpose to make device regions through said active layer and said buffer layer with extending to said crystal-defective layer by an ion-implantation technique.

4. A fabrication method of a compound semiconductor integrated circuit device as claimed in claim 3, wherein boron ions are used in said step of forming said crystal-defective layer.

5. A fabrication method of a compound semiconductor integrated circuit device, comprising the steps of:
forming a crystal-defective layer on a main surface of a semi-insulating GaAs substrate by an ion-implantation technique;
epitaxially growing a GaAs buffer layer on said crystal-defective layer at a temperature higher than that of a GaAs low-temperature buffer layer;
epitaxially growing on said buffer layer an active layer having a multi-layer structure which contains a GaAs layer and an AlGaAs layer; and
selectively forming a recess for isolation purpose to make device regions through said active layer with extending to said buffer layer by an etching technique.

6. A fabrication method of a compound semiconductor integrated circuit device as claimed in claim 5, wherein boron ions are used in said step of forming said crystal-defective layer.

7. A fabrication method of a compound semiconductor integrated circuit device as claimed in claim 5, wherein said step of growing said buffer layer includes a step of epitaxially growing a super-lattice layer composed of a GaAs layer and an AlGaAs layer and a step of epitaxially growing a GaAs layer.

8. A fabrication method of a compound semiconductor integrated circuit device as claimed in claim 5, wherein said steps of growing said buffer layer and said active layer are carried out by a Molecular Beam Epitaxy technique, respectively.

9. A fabrication method of a compound semiconductor integrated circuit device, comprising the steps of:
forming a crystal-defective layer on a main surface of a semi-insulating GaAs substrate by an ion-implantation technique;
epitaxially growing a GaAs buffer layer on said crystal-defective layer at a temperature higher than that of a GaAs low-temperature buffer layer;
epitaxially growing on said buffer layer an active layer having a multi-layer structure which contains a GaAs layer and an AlGaAs layer; and
selectively forming a crystal-defective region for isolation purpose to make device regions through said active layer and said buffer layer with extending to said crystal-defective layer by an ion-implantation technique.

10. A fabrication method of a compound semiconductor integrated circuit device as claimed in claim 9, wherein boron ions are used in said step of forming said crystal-defective layer.

11. A fabrication method of a compound semiconductor integrated circuit device as claimed in claim 9, wherein boron ions are used in said step of forming said crystal-defective layer, and a dose in said step of forming said crystal-defective layer is smaller than that in said step of forming said crystal-defective region.

12. A fabrication method of a compound semiconductor integrated circuit device as claimed in claim 9, wherein said step of growing said buffer layer includes a step of epitaxially growing a super-lattice layer composed of a GaAs layer and an AlGaAs layer and a step of epitaxially growing a GaAs layer.

13. A fabrication method of a compound semiconductor integrated circuit device as claimed in claim 9, wherein said steps of growing said buffer layer and said active layer are carried out by a Molecular Beam Epitaxy technique, respectively.

14. A fabrication method of a compound semiconductor integrated circuit device, comprising the steps of:
forming a crystal-defective layer on a main surface of a semi-insulating GaAs substrate by an ion-implantation technique;
epitaxially growing a GaAs buffer layer on said crystal-defective layer at a temperature higher than that of a GaAs low-temperature buffer layer;
epitaxially growing a GaAs active layer on said buffer layer; and
selectively forming a crystal-defective region for isolation purpose to make device regions through said active layer and said buffer layer with extending to said crystal-defective layer by an ion-implantation technique.

15. A fabrication method of a compound semiconductor integrated circuit device as claimed in claim 14, wherein boron ions are used in said step of forming said crystal-defective layer.

16. A fabrication method of a compound semiconductor integrated circuit device as claimed in claim 14, wherein boron ions are used in said step of forming said crystal-defective layer, and a dose in said step of forming said crystal-defective layer is smaller than that in said step of forming said crystal-defective region.

17. A fabrication method of a compound semiconductor integrated circuit device as claimed in claim 14, wherein said steps of growing said buffer layer and said active layer are carried out by a Metal-Organic Vapor Phase Epitaxy technique, respectively.
